# FASCICULE DE BREVET EUROPEEN

(11) **EP 2 171 652 B1**
(45) Date de publication et mention de la délivrance du brevet: **11.05.2011**
(21) Numéro de dépôt: 08776376.9
(22) Date de dépôt: 14.07.2008
(51) Int. Cl.: B41J 2/05

(54) **CIRCUIT PROTÉGÉ CONTRE L'ARRACHEMENT**
SCHALTUNG MIT SCHUTZ VOR DEM ABREISSEN
TEAR PROTECTED CIRCUIT

(30) Priorité: 31.07.2007 FR 0705600
(43) Date de publication de la demande: 07.04.2010
(73) Titulaire: STMicroelectronics (Rousset) SAS, 13790 Rousset (FR)
(72) Inventeur: STEFFEN, Francis, F-83470 Saint Maximin (FR); ASSAUD, Gilbert, F-13011 Marseille (FR)
(74) Mandataire: Marchand, André
(86) Numéro de dépôt international: PCT/IB2008/001888
(87) Numéro de publication internationale: WO 2009/016450

(56) Documents cités:
- EP-A- 0 710 924
- EP-A- 1 120 739
- WO-A-2004/032044
- DE-A1- 19 720 747

## Description

La présente invention concerne un circuit flexible, un micromodule réalisé à partir d'un tel circuit ainsi qu'un dispositif comprenant un tel circuit.

La présente invention concerne de façon générale les dispositifs comprenant un circuit électronique embarqué, notamment mais non exclusivement les cartouches d'encre.

Différents produits comme les cartouches pour imprimantes sont communément équipés d'un circuit intégré comprenant des données de gestion et d'authentification, qui est destiné à communiquer avec un système utilisateur. Le circuit intégré se présente sous la forme d'une microplaquette de semi-conducteur montée sur un circuit d'interconnexion qui est collé dans ou sur le boîtier de la cartouche. Le circuit d'interconnexion peut comporter un film polymère flexible et des pistes conductrices reliant des plages de contact du circuit à des contacts du circuit intégré.

Les données détenues par le circuit intégré peuvent être indispensables à la bonne utilisation du produit auquel il est associé et notamment son acceptation par le système utilisateur. Ainsi, la récupération du circuit intégré peut avoir un intérêt technique ou commercial, par exemple pour réaliser un produit de substitution. Pour ce faire, on peut procéder par décollement du circuit d'interconnexion sur lequel est fixé le circuit intégré et son recollement sur un boîtier recyclé voire contrefaisant.

Il peut ainsi être souhaité de commercialiser des produits comprenant un circuit intégré qui ne soit pas récupérable.

Le document EP-A-0 710 924, qui est considéré comme étant l'état de la technique le plus proche de l'objet de la revendication 1, décrit un circuit avec un substrat flexible, un élément électrique solidaire du substrat et présentant une caractéristique électrique. Le substrat comporte une cavité qui forme un orifice ti traversant le substrat à proximité de l'élément électrique ou d'une partie de l'élément électrique et favorisant une rupture de l'élément électrique entraînant une altération de sa caractéristique électrique en réponse à une flexion ou un étirement du substrat. Une pièce enfichable se trouve dans l'orifice et traverse l'orifice. Cette pièce comporte un élément électrique qui est relié électriquement à l'élément électrique solidaire du substrat.

L'invention prévoit un circuit selon la revendication 1 et un procédé de fabrication selon la revendication 9. Des modes de réalisation préférées sont définies dans les revendications dépendantes.

Dans ce qui suit sont décrits des exemples de mise en oeuvre de l'invention. Ces exemples sont décrits à titre non limitatif en relation avec les figures jointes parmi lesquelles :
- la figure 1A est une vue de dessus partielle d'un exemple de réalisation d'un circuit ;
- la figure 1B est une vue de dessous partielle du circuit de la figure 1A ;
- les figures 2A, 2B sont des vues partielles en coupe suivant différents axes de coupe du circuit de la figure 1A ;
- la figure 3A est une vue de dessus partielle d'un autre exemple de réalisation d'un circuit ;
- la figure 3B est une vue partielle en coupe du circuit de la figure 3A ;
- la figure 4A est une vue de dessus partielle d'un exemple de réalisation d'un micromodule ;
- la figure 4B est une vue en coupe du micromodule de la figure 4A ;
- la figure 4C montre le micromodule de la figure 4A fixé sur un support ;
- la figure 5A est une vue de dessus partielle d'un exemple de réalisation d'un micromodule selon l'invention, monté sur un support ;
- la figure 5B est une vue partielle, en coupe, du micromodule de la figure 5A et du support ;
- la figure 6 illustre une étape d'assemblage du micromodule de la figure 5A sur le support ;
- la figure 7 représente schématiquement une cartouche d'encre comprenant un micromodule selon l'invention ;
- la figure 8 illustre un exemple de réalisation d'un procédé de fabrication collective de micromodules , et
- la figure 9 est une vue de dessus d'encore un autre exemple de réalisation d'un micromodule selon l'invention.

Les exemples de réalisation de l'invention décrits dans ce qui suit visent essentiellement la rupture d'éléments électriques prenant la forme de pistes conductrices. Toutefois, le champ d'application de l'invention n'est pas limité à la rupture d'une piste conductrice. L'invention peut être appliquée à la destruction ou la simple déformation d'éléments électriques de type résistif, capacitif ou inductif. Peut notamment être visée la destruction pure et simple d'un élément résistif, capacitif ou inductif ou simplement une variation de sa caractéristique électrique (résistance, capacité électrique, ou inductance) suite à une déformation du substrat sur lequel l'élément est agencé. Une déformation d'un tel élément peut être détectée visuellement. Egalement, une variation de résistance, de capacitance ou d'inductance d'un tel élément, ainsi que l'apparition d'un circuit ouvert, peuvent être détectées électriquement et identifiées comme représentatives d'un stress anormal appliqué au produit concerné. Des actions peuvent être prévues suite à une telle détection, par exemple le blocage hardware ou logiciel d'un circuit intégré connecté aux éléments électriques ayant subi une déformation anormale.

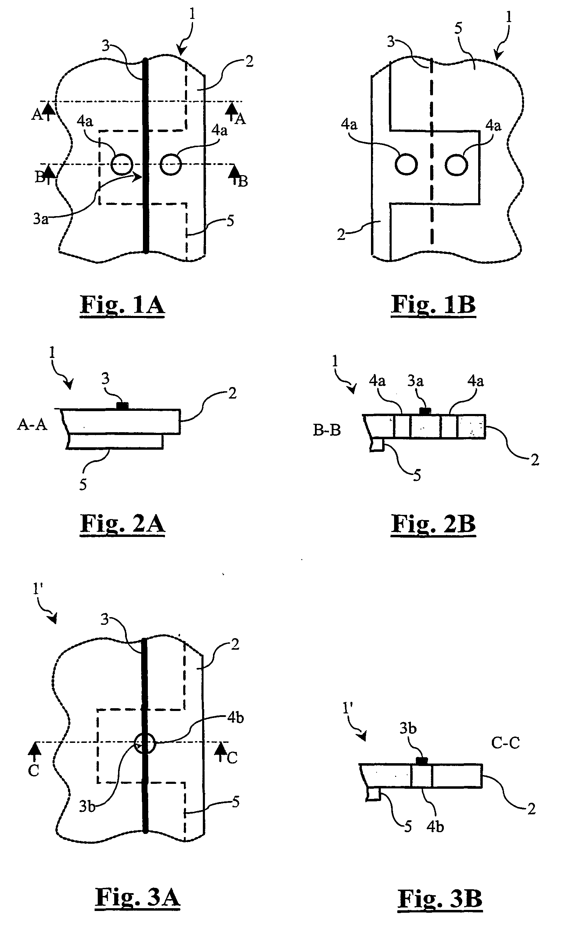

Les figures 1A et 1B sont des vues partielles d'un exemple de réalisation d'un circuit 1 . Le circuit est vu de dessus sur la figure 1A et de dessous sur la figure 1B. La figure 2A est une vue en coupe du circuit selon un axe de coupe AA et la figure 2B une vue en coupe de ce circuit selon un axe de coupe BB.

Le circuit 1 comprend un substrat 2 et au moins une piste électriquement conductrice 3 s'étendant sur la face avant du substrat 2. Le substrat 2 est de type flexible et est par exemple en un matériau polymère tel qu'une résine époxyde ou polyester. La piste est de préférence du type non flexible ou faiblement flexible et peut être en métal, par exemple en cuivre, ou en un alliage de métaux. La piste conductrice est susceptible de se rompre si elle subit une flexion ou un étirement au-delà d'un seuil d'élasticité du matériau qui la constitue.

L'invention prévoit ici de favoriser la rupture de la piste 3 en réponse à une flexion ou un étirement du substrat, afin de d'offrir une protection contre l'arrachement du circuit après que celui-ci a été collé sur un support. En d'autres termes, il s'agit ici de rendre le circuit inutilisable s'il a été arraché de son support d'origine.

A cet effet, selon le présent mode de réalisation, des cavités 4a sont pratiquées dans le substrat 2 de chaque côté de la piste 3, par exemple dans une région du substrat où la piste 3 forme un tronçon 3a sensiblement rectiligne. Les cavités 4a sont agencées à proximité du tronçon 3a et leur présence a pour effet de diminuer la résistance du substrat à la flexion ou à l'étirement le long d'une ligne s'étendant entre les deux cavités et passant sous la piste conductrice 3 (correspondant à l'axe BB sur la figure 1A). Une telle diminution de la résistance du substrat à la flexion ou à l'étirement implique que l'on favorise la flexion ou l'étirement de la piste et par conséquent sa rupture dans la région considérée.

Les cavités 4a sont ici des orifices qui débouchent sur la face arrière du substrat. Elles peuvent présenter une largeur ou un diamètre supérieur à la largeur du tronçon 3a et sont, en tout état de cause, suffisamment proches l'une de l'autre pour affaiblir localement le substrat en flexion ou en étirement. Les cavités 4a sont par exemple agencées à une distance de quelques centaines de micromètres l'une de l'autre, par exemple 200 à 500 micromètres, cette distance pouvant varier en fonction de la largeur du tronçon 3a de la piste conductrice et de la technique de réalisation utilisée (découpe mécanique, laser, etc.).

La piste conductrice 3 présente par exemple une épaisseur de l'ordre de 10 à 80 micromètres et une largeur de l'ordre de 20 à 100 micromètres dans le cas de réalisation par gravure par exemple, ces valeurs pouvant êtres beaucoup plus faibles (quelques centaines de nanomètres par exemple) en utilisant des techniques de dépôts de matériaux conducteurs ou résistifs.

Le substrat 2 présente par exemple une épaisseur de quelques micromètres à quelques centaines de micromètres, par exemple comprise entre 15 à 200 micromètres. Il va de soi que plus le substrat est fin, plus l'effet de rupture visé est atteint rapidement. Un compromis doit toutefois être fait pour que le substrat présente une flexibilité et une résistance à l'étirement appropriées, afin de ne pas rompre involontairement la piste conductrice 3 pendant la manipulation du substrat ou pendant sa fabrication. On pourra tirer profit d'une dégradation naturelle par l'effet du temps ou de l'environnement d'un matériau dont les caractéristiques en vieillissement et la proximité des cavités permettent de fragiliser naturellement. Le tronçon de piste 3a présente ici la même largeur que le reste de la piste conductrice 3 mais pourrait également être de moindre largeur afin de favoriser sa rupture.

Comme illustré sur la figure 1B, la face arrière du substrat 2 est recouverte d'une couche adhésive 5 permettant le collage du substrat sur un support (des exemples de réalisation de support seront décrits plus loin). La couche adhésive 5 est par exemple un film adhésif double face sensible à la pression (adhésif "PSA" pour "Pressure Sensitive Adhesive"), une colle de type cyanoacrylate ou une colle technique du type commercialisé sous la marque Hotmelt^{®}. La couche adhésive présente par exemple une épaisseur de l'ordre de quelques micromètres à une centaine de micromètres.

Selon un aspect , la face arrière du substrat 2 présente une zone d'épargne dépourvue de couche adhésive 5. Cette zone d'épargne, repérée par des traits pointillés sur la figure 1A, coïncide avec une région de la face avant du substrat où s'étendent le tronçon de piste 3a et les cavités 4a. Cette zone d'épargne favorise localement la flexion ou l'étirement du substrat lorsque celui-ci est décollé d'un support, d'une manière qui apparaitra clairement par la suite.

Diverses techniques classiques sont utilisables pour solidariser la piste conductrice 3 au substrat 2. La piste peut être assemblée sur le substrat par laminage à chaud ou être fixée sur celui-ci au moyen d'une couche adhésive. Si une technique de fixation par adhésif est utilisée, il convient de s'assurer que l'adhésif ne s'oppose pas à l'effet de rupture voulu par l'invention. Cependant, les couches adhésives utilisées en microélectronique sont généralement de très faible épaisseur et n'offrent aucune action de renfort qui pourrait retarder ou empêcher la rupture de la piste conductrice 3 en réponse à une flexion ou un étirement du substrat.

Les figures 3A, 3B représentent partiellement, respectivement par une vue de dessus et une vue en coupe, un autre exemple de réalisation d'un circuit 1' . Dans cet exemple, le substrat 2 présente une cavité 4b qui s'étend sous un tronçon 3b de la piste conductrice 3, à l'aplomb de celui-ci. Le tronçon de piste 3b s'étend ainsi au-dessus du vide et n'est pas porté par le substrat. La cavité 4b forme un point de flexion ou d'étirement privilégié du substrat, et par conséquent un point de rupture privilégié de la piste conductrice 3.

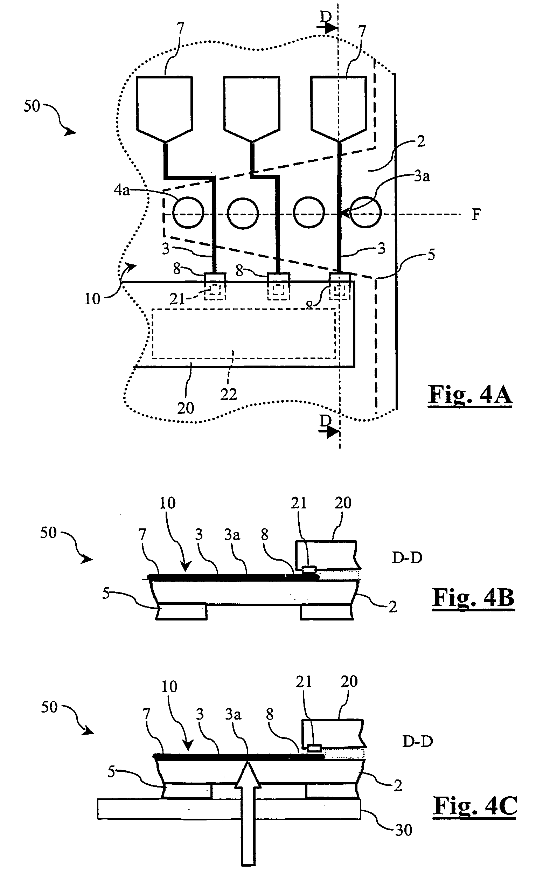

La figure 4A est une vue de dessus partielle d'un exemple de réalisation d'un micromodule 50 . La figure 4B est une vue en coupe du micromodule 50 selon un axe de coupe DD. Le micromodule 50 comprend un circuit 10 sur lequel est montée une microplaquette de semi-conducteur 20. La face avant de la microplaquette 20 présente des contacts 21 et une zone active 22 où est implanté un circuit intégré (non détaillé).

Le circuit 10 comprend un substrat 2, des pistes conductrices 3, des cavités 4a, des plages conductrices 7 et des plages conductrices 8. Les plages 7 forment des contacts de surface, accessibles de l'extérieur et permettant de connecter le micromodule 50 à une circuiterie externe. Chaque plage 7 est ici reliée électriquement à une plage 8 par l'intermédiaire d'une piste conductrice 3. Les plages 8 sont par ailleurs reliées électriquement à des contacts 21 de la microplaquette 20. Ces derniers sont ici directement soudés sur les plages 8 suivant la technique de montage "flip-chip" ("puce retournée"), la face avant de la microplaquette 20 étant orientée vers le circuit 10. Alternativement, les contacts 21 peuvent être collés sur les plages 8 au moyen d'une colle électriquement conductrice.

Comme décrit plus haut en relation avec les figures 1A, 1B, les cavités 4a sont disposées de chaque côté des pistes 3, de préférence dans une région où celles-ci forment des tronçons 3a sensiblement rectilignes. Les cavités sont agencées ici suivant une ligne F de flexion ou d'étirement privilégié du substrat, favorisant la rupture de tout ou partie des tronçons de piste 3a en réponse à une flexion globale du substrat et/ou un étirement de celui-ci. Comme précédemment, la face arrière du substrat 2 est revêtue d'une couche adhésive 5 et présente une zone d'épargne correspondant, sur la face avant du substrat, à la région où s'étendent les cavités 4a et les tronçons 3a, soit une zone coïncidant avec la ligne F de flexion ou d'étirement privilégié du substrat.

La figure 4C montre le micromodule 50 collé sur un support 30, en coupe selon l'axe de coupe DD. L'axe de coupe DD est ici aligné avec l'une des pistes conductrices 3 et est perpendiculaire à la ligne F de flexion ou d'étirement privilégié du substrat. La ligne F, vue ici en coupe, forme ainsi un point repéré par une flèche. Une tentative d'arrachement du circuit 10 relativement au support 30 engendre une flexion et un effet d'étirement qui engendrent eux-mêmes des déformations de plus grande amplitude au voisinage des cavités 4a, qui conduisent à la rupture de tout ou partie des tronçons de piste 3a. Ainsi, une tentative d'arrachement du circuit 10 détruit partiellement celui-ci.

L'absence de couche adhésive 5 à l'aplomb des tronçons 3a favorise également la rupture des pistes. En effet, pendant le décollement du substrat, un effort d'une certaine intensité soit être appliqué pour rompre la couche adhésive 5. Lorsque la zone d'épargne est atteinte, le mouvement d'arrachement s'accélère et l'énergie libérée provoque un étirement brutal du substrat et la rupture des pistes conductrices.

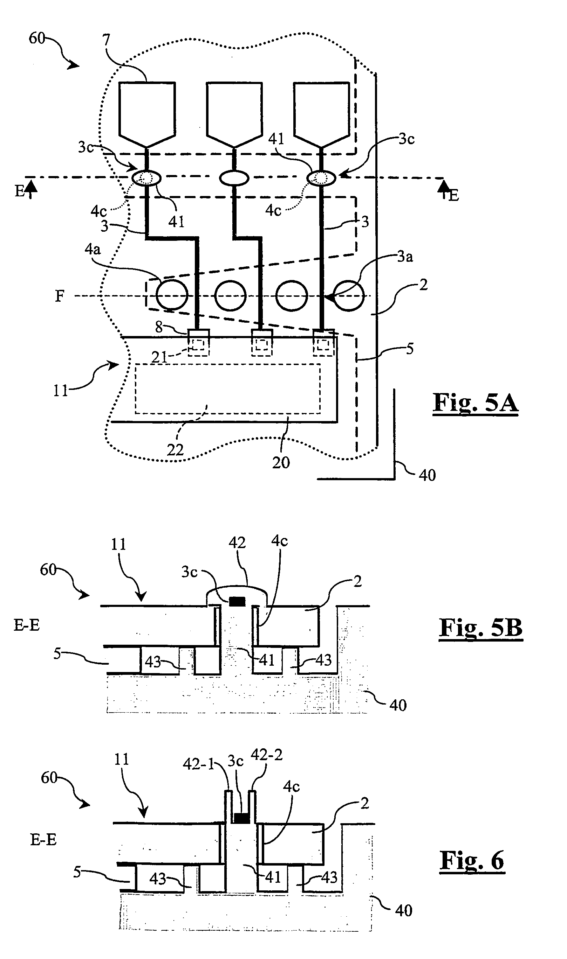

La figure 5A est une vue de dessus partielle d'un exemple de réalisation d'un micromodule 60 selon l'invention, le micromodule 60 étant représenté agencé sur un support 40. La figure 5B est une vue en coupe du micromodule selon un axe de coupe EE. Comme le micromodule 50, le micromodule 60 comprend un circuit 11 sur lequel est montée une microplaquette de semi-conducteur 20 comprenant des contacts 21 et une zone active 22. Le circuit 11 comprend comme précédemment un substrat 2, des pistes conductrices 3, des cavités 4a et des plages conductrices 7 reliées à des plages conductrices 8 par l'intermédiaire des pistes conductrice 3. Les contacts 21 de la microplaquette 20 sont connectés aux plages 8 de la même manière que précédemment (montage "flip-chip"). Egalement, les cavités 4a sont disposées de part et d'autre de tronçons de piste 3a, suivant une ligne F de flexion ou d'étirement privilégié du substrat.

Selon un autre aspect de l'invention, des orifices 4c sont pratiqués dans le substrat 2, à l'aplomb des pistes conductrices 3, dans une région où celles-ci forment des tronçons 3c distincts des tronçons 3a. Des parties en saillie 41 solidaires du support 40 traversent les orifices 4c et présentent, à leur extrémité distale, des renflements 42 emprisonnant les tronçons 3c, comme cela apparait sur la figure 5B. Le support 40 comporte en outre des plots 43 disposés à proximité des parties en saillie 41, sur lesquels s'appuie la face arrière du substrat 2.

La figure 6 illustre la formation d'un renflement 42 pendant l'assemblage du micromodule 60 sur le support 40. L'extrémité distale de chaque saillie 41 comprend initialement deux parois parallèles 42-1 et 42-2 délimitant une gorge dans laquelle vient se loger un tronçon de piste 3c. Les parois 42-1, 42-2 sont ensuite ramollies au moyen d'un instrument chauffant (thermode) ou tout autre moyen (par exemple un flux d'air chaud) et fusionnent pour former le renflement 42. Les parties en saillie et leurs renflements 42 forment ainsi des sortes de rivets qui emprisonnent de façon irréversible les tronçons de piste 3c, de sorte que toute tentative de séparation du substrat 2 relativement au support 40 entraine immédiatement la destruction des tronçons de piste 3c.

Sur la face arrière du substrat 2, la couche adhésive 5 précédemment décrite peut être prévue pour maintenir le micromodule 60 sur le support 40. Elle permet également de supprimer les contraintes mécaniques qui pourraient s'exercer sur les tronçons de piste 3c si le substrat n'était pas solidement maintenu sur le support. Comme précédemment, la couche adhésive 5 peut présenter des zones d'épargne, notamment dans une région correspondant à la région en face avant comprenant les cavités 4a et les tronçons 3a, ainsi que dans la région où s'étendent les orifices 4c.

L'homme de l'art notera qu'un autre moyen de maintien du micromodule 60 sur le support 40 pourrait ici être prévu. Par exemple, l'utilisation de "rivets" tel que celui-ci décrit ci-dessus pourrait être généralisée y compris dans des régions du substrat où ne passent pas les pistes conductrices.

Pour résumer ce qui précède, un circuit ou un micromodule protégé contre l'arrachement suivant les idées et principes de l'invention peut présenter au moins la caractéristique suivante : - au moins un tronçon de piste 3c emprisonné dans une partie en saillie 41 traversant le substrat,

L'invention est applicable à tout type de circuit comportant un substrat flexible. Un micromodule selon l'invention peut comprendre plusieurs autres microplaquettes de semi-conducteur ou n'en comprendre aucune. Un micromodule selon l'invention peut par exemple ne comprendre que des composants discrets montés sur le circuit, tels des résistances, des condensateurs, des transistors, etc.

D'autre part, le support 30, 40 représenté schématiquement sur les figures 4A, 4B, 5A, 5B peut être tout type de support et notamment une paroi interne ou externe d'un boitier d'un dispositif électronique, mécanique, électromécanique, pneumatique... recevant un micromodule électronique et pour lequel il est souhaité que le micromodule ne soit pas réutilisé par des tiers.

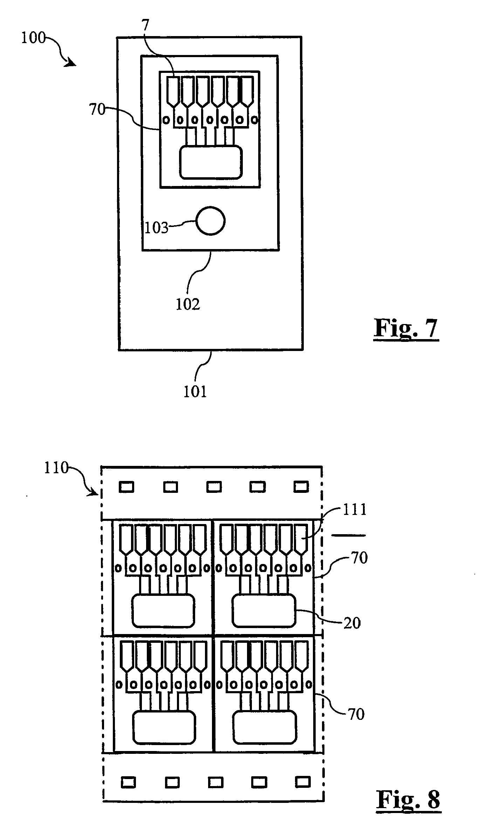

A titre d'exemple d'application, la figure 7 représente schématiquement, vue de dessous, une cartouche 100 pour imprimante à jet d'encre sur laquelle est fixé un micromodule 70 selon un quelconque mode de réalisation de l'invention. La cartouche 100 présente un boîtier 101 comprenant un réservoir d'encre. Le boîtier 101 est muni d'une paroi inférieure 102 dans laquelle est ménagée une ouverture 103 assurant l'écoulement de l'encre vers une tête d'impression. Le micromodule 70 est fixé sur la paroi 102 par l'intermédiaire de la couche adhésive décrite plus haut. Des plages conductrices 7 du micromodule forment des contacts externes permettant de relier électriquement le micromodule à la tête d'impression. Le boîtier 101, et en particulier la paroi 102, sont par exemple en un matériau synthétique tel que du polypropylène.

La figure 8 illustre un exemple de réalisation d'un procédé de fabrication de micromodules 70 . Les micromodules sont réalisés ici collectivement à partir d'un substrat commun en forme de bande 110 ("tape"), qui défile sur une chaine de fabrication. Simultanément, une bande métallique est découpée, gravée ou estampée pour former un motif conducteur 111 appelé "leadframe" qui est assemblé avec la bande 110 par laminage à chaud ou par collage, afin de former des pistes conductrices et des plages de contact. Après assemblage de la bande 110 et du motif conducteur 111, des microplaquettes de semi-conducteur 20 sont montées sur la bande 110 en position retournée (technique "flip chip") et leurs contacts sont connectés à des plages de contact du motif conducteur 111.

Ce procédé de fabrication comprend une étape de formation des cavités ou orifices 4a, 4b, 4c décrits plus haut. Cette étape peut être mise en oeuvre avant l'assemblage de la bande 110 et du motif conducteur 111. Les cavités ou orifices 4a, 4b, 4c sont réalisés par estampage, gravure chimique, perçage au laser du substrat ou toute autre méthode de perçage connue, par exemple au moyen d'un outil rotatif. Les cavités 4a, 4b peuvent également être borgnes et être réalisées par déformation plastique du substrat entraînant un fluage localisé de celui-ci.

Ce procédé peut d'ailleurs être appliqué à la fabrication de circuits, en supprimant l'étape de montage des circuits intégrés 20 (ou autres composants électroniques), ces derniers pouvant être montés ultérieurement.

Au terme du processus de fabrication, une couche adhésive peut être déposée sur la face arrière de la bande 110. Cette étape peut toutefois être conduite ultérieurement, après conditionnement et transport de la bande 110 sur un lieu de fabrication d'un produit final. Dans ce cas, la bande 110 est revêtue de la couche adhésive sur le lieu de fabrication du produit final, puis est découpée pour individualiser les micromodules 70, qui sont ensuite montés sur des produits finaux.

Il apparaîtra clairement à l'homme de l'art que la présente invention est susceptible de diverses autres variantes de réalisation et applications. Notamment, bien que l'on ait décrit dans ce qui précède une application de l'invention à la réalisation d'un micromodule du type "à contact", l'invention est également applicable à la réalisation de micromodules du type "sans contact", par exemple des micromodules RFID (Radiofrequency Indentification) ou des étiquettes électroniques sans contact.

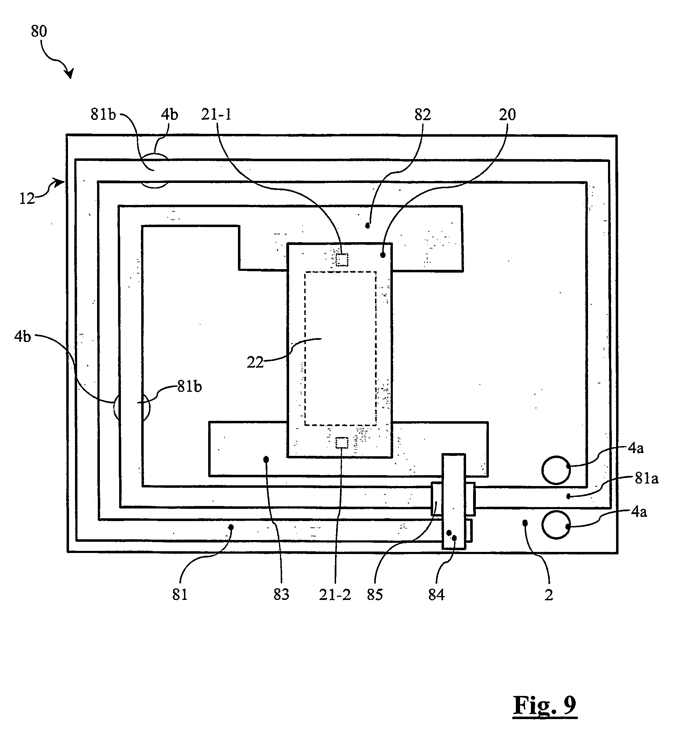

Un exemple de réalisation d'un micromodule sans contact est représenté sur la figure 9. Le micromodule 80 comprend un circuit 12 et une microplaquette de semi-conducteur 20 comprenant des contacts 21-1, 21-2 et une région active 22 où est implanté un circuit intégré dit "sans contact", fonctionnant par couplage inductif ou par couplage électrique. Le circuit 12 comprend un substrat 2 et une piste conductrice 81 en forme d'antenne, ici une bobine d'antenne. Une première plage de contact 82 s'étend à une première extrémité de la piste 81, et une seconde plage de contact 83 est reliée à une seconde extrémité de la piste 81 au moyen d'un pont conducteur 84 formé sur un coussinet électriquement isolant 85. La microplaquette de semi-conducteur 20 est montée retournée, ses contacts 21-1, 21-2 étant soudés ou collés sur les plages 82, 83, respectivement. Le substrat 2 comprend deux cavités 4a agencées de chaque côté d'un premier tronçon 81a de la piste 81, et deux autres cavités 4b agencées à l'aplomb d'un deuxième et d'un troisième tronçon 81b de la piste 81. Le micromodule est collé sur un support (non représenté). L'arrachement du micromodule 80 de son support provoque le sectionnement de la piste 81 au niveau de l'un des tronçons 81a, 81b suite à la flexion et l'étirement du substrat pendant l'arrachement. Ainsi, l'antenne ne fonctionne plus et le micromodule devient inutilisable. L'invention peut également être appliquée à des éléments capacitifs d'un circuit d'antenne présentant une fréquence d'accord, de manière qu'une déformation du substrat détruise ces éléments ou modifie simplement leur valeur capacitive de manière à désaccorder le circuit d'antenne et le rendre inutilisable dans une plage de fréquences de travail au voisinage de la fréquence d'accord. Enfin, l'invention peut également être appliquée à des éléments électriques enterrés dès lors que des cavités créées sous les éléments ou à proximité de ceux-ci permettent de provoquer une déformation ayant un impact significatif sur leurs caractéristiques électriques ou une rupture de ceux-ci en réponse à une déformation du substrat.

## Revendications

1. Circuit (1, 1', 10, 11, 12), comprenant :
- un substrat flexible (2),
- au moins un élément électrique (3, 81) solidaire du substrat et présentant une caractéristique électrique, dans lequel le substrat (2) comporte au moins une cavité (4a, 4b, 4c) agencée à proximité de l'élément électrique ou d'une partie de l'élément électrique (3a, 3b, 3c, 81a, 81b) et favorisant une rupture de l'élément électrique ou une déformation de l'élément électrique entrainant une altération de sa caractéristique électrique, en réponse à une flexion ou un étirement du substrat, ladite cavité (4c) forme un orifice traversant le substrat,
**caractérisé en ce que** l'élément électrique (3) comprend une partie (3c) prisonnière de l'extrémité distale (42) d'une pièce (41) traversant l'orifice (4c), pour provoquer la rupture de l'élément électrique en réponse à un déplacement du substrat relativement à la pièce (41) traversant l'orifice.

2. Circuit selon la revendication 1, dans lequel le substrat (2) est en un matériau polymère.

3. Circuit selon l'une des revendications 1 et 2, dans lequel une face arrière du substrat (2) est revêtue d'une couche adhésive (5) et présente une zone d'épargne dépourvue de couche adhésive dans une région correspondant sensiblement à une région en face avant où se trouvent la cavité (4a, 4b, 4c) et l'élément électrique (3a, 3b, 3c, 81a, 81b).

4. Circuit selon l'une des revendications 1 à 3, dans lequel l'élément électrique est une piste conductrice ou un tronçon de piste conductrice.

5. Circuit selon l'une des revendications 1 à 4, dans lequel l'élément électrique est un élément résistif, capacitif, ou inductif.

6. Circuit selon l'une des revendications 1 à 5, dans lequel l'élément électrique (81) forme une antenne.

7. Dispositif (100) comprenant un circuit (1, 1', 10, 11, 12) selon l'une des revendications 1 à 6 et un support (30, 40, 102) recevant le circuit, dans lequel :
- le support (40) présente au moins une partie en saillie (41) traversant l'orifice (4c) pratiqué dans le circuit, et
- la partie en saillie (41) du support forme la pièce traversant l'orifice.

8. Dispositif selon la revendication 7, prenant la forme d'une cartouche d'encre (100) ayant un boitier dont une partie forme le support (102).

9. Procédé de fabrication d'un dispositif (100), qui comprend :
- des étapes de fabrication d'un circuit (1, 1', 10, 11, 12) comprenant un substrat flexible (2), au moins un élément électrique (3, 81) solidaire du substrat et présentant une caractéristique électrique, le substrat (2) comportant au moins une cavité (4a, 4b, 4c) agencée à proximité de l'élément électrique ou d'une partie de l'élément électrique et favorisant une rupture de l'élément électrique ou une déformation de l'élément électrique entrainant une altération de sa caractéristique électrique, en réponse à une flexion ou un étirement du substrat la cavité forme un orifice traversant le substrat, et
- une étape de collage de la face arrière du circuit sur un support (30, 40, 102), au moyen d'un adhésif (5), **caractérisé en ce qu'**il comporte des étapes consistant à :
- prévoir au moins une partie en saillie (41) solidaire du support (40),
- fixer le circuit sur le support de manière que la partie en saillie (41) traverse l'orifice correspondant (4c), et
- emprisonner une partie (3c) de l'élément électrique dans la partie en saillie (41), pour provoquer la rupture de l'élément électrique en réponse à un déplacement du substrat relativement au support (40).

10. Procédé selon la revendication 9, comprenant une étape consistant à prévoir sur la face arrière du substrat (2) une zone d'épargne dépourvue d'adhésif (5) de manière à favoriser la rupture ou la déformation de l'élément électrique en réponse à une tentative d'arrachement du circuit relativement au support.

11. Procédé selon l'une des revendications 9 et 10, dans lequel l'étape d'emprisonnement de la partie (3c) de l'élément électrique comprend une étape de fusion de deux éléments (42-1, 42-2) de la partie en saillie (41).

12. Procédé selon l'une des revendications 9 à 11, comprenant en outre une étape consistant à pratiquer au moins deux cavités (4a) de chaque côté de l'élément électrique (3a, 81a) pour former entre les deux cavités une ligne de flexion ou d'étirement privilégié du substrat favorisant la rupture ou la déformation de l'élément électrique en réponse à une flexion ou un étirement du substrat.

13. Procédé selon l'une des revendications 9 à 12, dans lequel l'élément électrique est une piste conductrice ou un tronçon de piste conductrice.

14. Procédé selon l'une des revendications 9 à 13, dans lequel l'élément électrique est un élément résistif, capacitif, ou inductif.

15. Procédé selon l'une des revendications 9 à 14, appliqué à la fabrication d'une cartouche d'encre (100) comprenant un boitier, et comprenant une étape consistant à utiliser comme support (102) une paroi du boîtier de la cartouche d'encre.

## Claims

1. Circuit (1, 1', 10, 11, 12) comprising:
- a flexible substrate (2),
- at least one electric element (3, 81) attached to the substrate and having an electric feature,
wherein the substrate (2) comprises at least one cavity (4a, 4b, 4c) arranged near the electric element or a part of the electric element (3a, 3b, 3c, 81a, 81b) and helping a break of the electric element or a distortion of the electric element causing a change in the electric feature thereof, in response to a flexion or stretching of the substrate, the cavity (4c) forms an orifice passing through the substrate,
**characterized in that** the electric element (3) comprises a part (3c) which is captive of the distal end (42) of a part (41) passing through the orifice (4c), to trigger the break of the electric element in response to the substrate moving in relation to the part (41) passing through the orifice.

2. Circuit according to claim 1, wherein the substrate (2) is made of a polymer material.

3. Circuit according to one of claims 1 and 2, wherein a rear face of the substrate (2) is covered by an adhesive layer (5) and has a free area without adhesive layer in an area substantially corresponding to an area in front face where the cavity (4a, 4b, 4c) and the electric element (3a, 3b, 3c, 81a, 81b) are located.

4. Circuit according to one of claims 1 to 3, wherein the electric element is a conductive path or a segment of a conductive path.

5. Circuit according to one of claims 1 to 4, wherein the electric element is a resistive, capacitive or inductive element.

6. Circuit according to one of claims 1 to 5, wherein the electric element (81) forms an antenna.

7. Device (100) comprising a circuit (1, 1', 10, 11, 12) according to one of claims 1 to 6 and a support (30, 40, 102) receiving the circuit, wherein:
- the support (40) has at least one projecting part (41) passing through the orifice (4c) made in the circuit, and
- the projecting part (41) of the support forms the part passing through the orifice.

8. Device according to claim 7, taking the shape of an ink cartridge (100) having a case a part of which makes the support (102).

9. Method for manufacturing a device (100), which comprises:
- steps of manufacturing a circuit (1, 1', 10, 11, 12) comprising a flexible substrate (2), at least one electric element (3, 81) attached to the substrate and having an electric feature, the substrate (2) comprising at least one cavity (4a, 4b, 4c) arranged near the electric element or a part of the electric element and helping a break of the electric element or a distortion of the electric element causing a change in the electric feature thereof, in response to a flexion or stretching of the substrate, the cavity forms an orifice passing through the substrate, and
- a step of gluing the rear face of the circuit to a support (30, 40, 102) using an adhesive (5),
**characterized in that** it comprises the steps of:
- providing at least one projecting part (41) attached to the support (40),
- fixing the circuit onto the support so that the projecting part (41) passes through the corresponding orifice (4c), and
- making a part (3c) of the electric element captive of the projecting part (41), to trigger the break of the electric element in response to the substrate moving in relation to the support (40).

10. Method according to claim 9, comprising a step of providing on the rear face of the substrate (2) a free area without adhesive (5) in order to help the break or distortion of the electric element in response to an attempt of tearing the circuit off the support.

11. Method according to one of claims 9 and 10, wherein the step of capturing the part (3c) of the electrical element comprises a step of melting two elements (42-1, 42-2) of the projecting part (41).

12. Method according to one of claims 9 to 11, also comprising a step of making at least two cavities (4a) on each side of the electric element (3a, 81a) to form between both cavities a flexion or stretch line preferred by the substrate helping the break or distortion of the electric element in response to a flexion or stretching of the substrate.

13. Method according to one of claims 9 to 12, wherein the electric element is a conductive path or a segment of conductive path.

14. Method according to one of claims 9 to 13, wherein the electric element is a resistive, capacitive or inductive element.

15. Method according to one of claims 9 to 14, applied to the manufacture of an ink cartridge (100) comprising a case, and comprising a step of using as support (102) a wall of the case of the ink cartridge.

## Patentansprüche

1. Schaltkreis (1, 1', 10, 11, 12), umfassend:
- ein flexibles Substrat (2),
- zumindest ein elektrisches Element (3, 81), das mit dem Substrat verbunden ist und eine elektrische Charakteristik aufweist,
in dem das Substrat (2) zumindest einen Hohlraum (4a, 4b, 4c) umfasst, der in der Nähe des elektrischen Elements oder eines Teils des elektrischen Elements (3a, 3b, 3c, 81a, 81b) angeordnet ist, und der einen Bruch des elektrischen Elements oder eine Verformung des elektrischen Elements fördert, eine Veränderung seiner elektrischen Charakteristik bewirkend, als Antwort auf eine Biegung oder eine Dehnung des Substrats, wobei der Hohlraum (4c) ein das Substrat durchquerendes Loch bildet,
**dadurch gekennzeichnet, dass** das elektrische Element (3) einen Bereich (3c) umfasst, der im distalen Ende (42) eines das Loch (4c) durchquerenden Teils (41) eingeschlossen ist, um den Bruch des elektrischen Elements als Antwort auf eine Verschiebung des Substrats im Verhältnis zum das Loch durchquerenden Teil (41) hervorzurufen.

2. Schaltkreis nach Anspruch 1, in dem das Substrat (2) aus einem Polymermaterial ist.

3. Schaltkreis nach einem der Ansprüche 1 und 2, in dem eine Rückseite des Substrats (2) mit einer Klebeschicht (5) verkleidet ist und eine Sparzone ohne Klebeschicht in einem Gebiet aufweist, das im Wesentlichen einem Gebiet an der Vorderseite entspricht, wo sich der Hohlraum (4a, 4b, 4c) und das elektrische Element (3a, 3b, 3c, 81a, 81b) befinden.

4. Schaltkreis nach einem der Ansprüche 1 bis 3, in dem das elektrische Element eine Leiterbahn oder ein Leiterbahnabschnitt ist.

5. Schaltkreis nach einem der Ansprüche 1 bis 4, in dem das elektrische Element ein widerstandsbehaftetes, kapazitives oder induktives Element ist.

6. Schaltkreis nach einem der Ansprüche 1 bis 5, in dem das elektrische Element (81) eine Antenne bildet.

7. Vorrichtung (100) umfassend einen Schaltkreis (1, 1', 10, 11, 12) nach einem der Ansprüche 1 bis 6 und einen Träger (30, 40, 102), der den Schaltkreis aufnimmt, in der:
- der Träger (40) zumindest einen vorstehenden Bereich (41) aufweist, der das Loch (4c) im Schaltkreis durchquert, und
- der vorstehende Bereich (41) des Trägers den das Loch durchquerenden Teil bildet.

8. Vorrichtung nach Anspruch 7, die die Form einer Tintenpatrone (100) mit einem Gehäuse, von dem ein Bereich den Träger (102) bildet, annimmt.

9. Verfahren zur Herstellung einer Vorrichtung (100), das Folgendes umfasst:
- Schritte zur Herstellung eines Schaltkreises (1, 1', 10, 11, 12) umfassend ein flexibles Substrat (2), zumindest ein elektrisches Element (3, 81), das mit dem Substrat verbunden ist und eine elektrische Charakteristik aufweist, wobei das Substrat (2) zumindest einen Hohlraum (4a, 4b, 4c) umfasst, der in der Nähe des elektrischen Elements oder eines Teils des elektrischen Element angeordnet ist, und der einen Bruch des elektrischen Elements oder eine Verformung des elektrischen Elements fördert, eine Veränderung seiner elektrischen Charakteristik bewirkend, als Antwort auf eine Biegung oder eine Dehnung des Substrats, wobei der Hohlraum ein das Substrat durchquerendes Loch bildet, und
- einen Schritt der Verklebung der Rückseite des Schaltkreises auf einen Träger (30, 40, 102) mit Hilfe eines Klebstoffs (5),
**dadurch gekennzeichnet, dass** es Schritte umfasst, die sich aus Folgendem zusammen setzen:
- zumindest einen vorstehenden Bereich (41), der mit dem Träger (40) verbunden ist, vorsehen,
- den Schaltkreis derart auf dem Träger befestigen, dass der vorstehende Bereich (41) das entsprechende Loch durchquert (4c), und
- einen Bereich (3c) des elektrischen Elements im vorstehenden Bereich (41) einschließen, um den Bruch des elektrischen Elements als Antwort auf eine Verschiebung des Substrats im Verhältnis zum Träger (40) hervorzurufen.

10. Verfahren nach Anspruch 9, umfassend einen Schritt, der darin besteht, derart auf der Rückseite des Substrats (2) eine Sparzone ohne Klebstoff (5) vorzusehen, dass der Bruch oder die Verformung des elektrischen Elements als Antwort auf einen Abreißversuch des Schaltkreises im Verhältnis zum Träger gefördert wird.

11. Verfahren nach einem der Ansprüche 9 und 10, in dem der Schritt des Einschließens des Bereichs (3c) des elektrischen Elements einen Schritt der Fusion von zwei Elementen (42-1, 42-2) des vorstehenden Bereichs (41) umfasst.

12. Verfahren nach einem der Ansprüche 9 bis 11, ferner umfassend einen Schritt, der darin besteht, zumindest zwei Hohlräume (4a) beiderseitig des elektrischen Elements (3a, 81a) vorzusehen, um zwischen den beiden Höhlräumen eine bevorzugte Biege- oder Dehnlinie des Substrats zu bilden, die den Bruch oder die Verformung des elektrischen Elements als Antwort auf eine Biegung oder eine Dehnung des Substrats fördert.

13. Verfahren nach einem der Ansprüche 9 bis 12, in dem das elektrische Element eine Leiterbahn oder ein Leiterbahnabschnitt ist.

14. Verfahren nach einem der Ansprüche 9 bis 13, in dem das elektrische Element ein widerstandsbehaftetes, kapazitives oder induktives Element ist.

15. Verfahren nach einem der Ansprüche 9 bis 14, angewendet an die Herstellung einer Tintenpatrone (100) umfassend ein Gehäuse, und umfassend einen Schritt, der darin besteht, eine Wand des Gehäuses der Tintenpatrone als Träger (102) zu verwenden.
